(19) Europäisches Patentamt
European Patent Office
Office européen des brevets

(11) Veröffentlichungsnummer: **0 231 456 B1**

(12) **EUROPÄISCHE PATENTSCHRIFT**

(45) Veröffentlichungstag der Patentschrift: 26.06.91

(51) Int. Cl.⁵: **H05K 7/20**

(21) Anmeldenummer: 86116120.6

(22) Anmeldetag: 21.11.86

(54) Verfahren und Vorrichtung zum Abführen der Verlustwärme wenigstens einer Baugruppe elektrischer Elemente.

(30) Priorität: 13.12.85 CH 5329/85
20.06.86 CH 2496/86

(43) Veröffentlichungstag der Anmeldung:
12.08.87 Patentblatt 87/33

(45) Bekanntmachung des Hinweises auf die Patenterteilung:
26.06.91 Patentblatt 91/26

(84) Benannte Vertragsstaaten:
AT CH DE ES FR GB IT LI NL SE

(56) Entgegenhaltungen:
EP-A- 0 052 747
DE-A- 2 046 750
DE-A- 2 801 660
DE-A- 3 244 654

WISSENSCHAFTLICHE BERICHTE
A.E.G.-TELEFUNKEN, Jrg. 51, Nr. 1, 1978, Seiten 30-39, Berlin, DE; P. HEINEMEYER et al.:
"Siedekühlung für Leistungshalbleiter"

ZEITSCHRIFT FEINWERKTECHNIK & MESS-TECHNIK, Band 7, Oktober/November 1983, Seiten 333-336, München, DE; H. GERBER:
"Methodische Auswahl von Kühlsystemen

für elektronische Geräte"

(73) Patentinhaber: Ascom Hasler AG
Belpstrasse 23
CH-3000 Bern 14(CH)

(72) Erfinder: Ulrich, Bohdan
Holzmattweg 4
CH-3122 Kehrsatz(CH)
Erfinder: Diggelmann, Hans, Dr.
Strittenweg
CH-3176 Neuenegg(CH)

(74) Vertreter: Keller, René, Dr. et al
Patentanwälte Hartmut Keller, Dr. René Keller Postfach 12
CH-3000 Bern 7(CH)

## Beschreibung

Die Erfindung betrifft eine Vorrichtung zum Abführen der Verlustwärme von mehreren etagenweise übereinander angeordneten Baugruppen elektrischer Elemente gemäss dem Oberbegriff des Patentanspruchs 1.

Eine Vorrichtung dieser Art ist aus der DE-A-20 46 750 bekannt. Die bekannte Vorrichtung hat mehrere in Abständen übereinander angeordnete Verdampfer-Module. In die Kammern der kastenartigen Verdampfer-Module ragen wärmeleitende Stifte, die mit ihren durch die Kammerwandung hindurchgeführten Enden an den elektronischen Chips befestigt sind. Jede Modulkammer hat nahe ihrer Decke einen oberen Auslassstutzen und nahe ihres Bodens einen unteren Einlassstutzen. Die oberen Auslassstutzen der Kammern sind über je ein Ventil an je einen Zweigabschnitt eines ersten Schlauchs, die unteren Auslassstutzen über je ein Ventil an je einen Zweigabschnitt eines zweiten Schlauchs angeschlossen. Oberhalb der Verdampfer-Module befindet sich ein Kondensator, an dessen Einlass der erste Schlauch und an dessen Auslass der zweite Schlauch angeschlossen ist. Der Kondensator, die Verdampfer-Module und die beiden Schläuche bilden eine druckdicht geschlossene Einheit, welche mit einer Fluoro-Kohlenstoffflüssigkeit soweit gefüllt ist, dass der Kondensator teilweise gefüllt ist. Infolge der durch die Wärmeleitstifte der Flüssigkeit in den Modulkammern zugeleiteten Verlustwärme der elektronischen Chips entsteht ein stetiger Dampf-Flüssigkeits-Kreislauf von den Modulkammern durch den ersten Schlauch nach oben zum die Wärme an einen Wärmeträger abgebenden Kondensator und von diesem durch den zweiten Schlauch nach unten zurück zu den Modulkammern. Weil alle Verdampfer parallel zueinander mit dem Kondensator verbunden sind, wird ihnen durch den Kühlkreislauf je nach ihrer Wärmebelastung und damit der Menge verdampfter Flüssigkeit die jeweils erforderliche Menge kondensierter Flüssigkeit zurückgeführt, so dass stets ausreichend Flüssigkeit zum Verdampfen und damit zur Konstanthaltung der Temperatur in allen Verdampfern vorhanden ist.

Die Kühlvorrichtung gemäss DE-A-3 244 654 hat zwischen den Etagen je einen Luftkühler, der die durch ein Gebläse von unten nach oben durch das Gestell strömende Luft rückkühlt, wobei die Luftkühler durch mit Kühlrippen versehene Rohrschlangen einer üblichen Kühlanlage gebildet sind. Bei der aus der EP-A-O 052 747 bekannten Vorrichtung erfolgt die Kühlung über eine Vielzahl von durch das Gehäuse hindurchführenden Heatpipes, die miteinander und mit einer mittels einer Wärmepumpe gekühlten Sammelschiene verbunden sind. Bei der aus der DE-A-28 01 660 bekannten Vorrichtung ist an jede Baugruppe ein mit Kühlrippen versehenes Wellrohr geführt. Die aus der SU-A-429 565 bekannte Vorrichtung hat für jedes elektrische Element zwei Verdampfer, alle Verdampfer sind durch Zweigrohre mit in Reservoire mündenden Rohrleitungen verbunden und die Reservoire sind schliesslich mit dem Kondensator verbunden. Bei der aus der US-A-3 817 321 bekannten Vorrichtung sind in ähnlicher Weise an den Bauelementen angeordnete Verdampfer durch mehrere verzweigte Rohr-leitungen mit einem an einen Kondensator angeschlossenen Gefäss verbunden.

Aufgabe der Erfindung ist es, eine Vorrichtung der eingangs genannten Art für die Abführung auch hoher Verlustwärmemengen einer Vielzahl etagenweise übereinander angeordneter Baugruppen zu schaffen, die einfach und preiswert herstellbar ist.

Die erfindungsgemässe Lösung dieser Aufgabe ist Gegenstand des Anspruchs 1. Bevorzugte Ausführungsarten der Erfindung sind Gegenstand der abhängigen Ansprüche.

Im folgenden werden eine bekannte Kühlvorrichtung und Ausführungsbeispiele der Erfindung anhand der Zeichnung näher erläutert. Es zeigen:

Fig. 1     eine perspektivische Darstellung eines Teils eines Elektronikgeräts mit einer bekannten Kühlvorrichtung,

Fig. 2a)   eine Vorderansicht einer erfindungsgemässen Vorrichtung, welche die Rückwand eines etagenweise aufgeteilten Elektronikgestells bildet,

Fig. 2b)   eine Seitenansicht der Vorrichtung von Fig. 2a) mit dem Elektronikgestell,

Fig. 3a)   eine Fig. 2a) entsprechende Vorderansicht einer ebenfalls die Rückwand eines Elektronikgestells bildenden Variante der Vorrichtung,

Fig. 3b)   eine Fig. 2b) entsprechende Seitenansicht der Variante mit dem Elektronikgestell,

Fig. 4     einen Schnitt durch einen Teil der Variante, in grösserem Massstab, und

Fig. 5     einen vertikalen Schnitt durch einen Teil eines Verdampfers und der mit diesem verbundenen elektrischen Elemente einer weiteren Variante der erfindungsgemässen Vorrichtung, in grösserem Massstab.

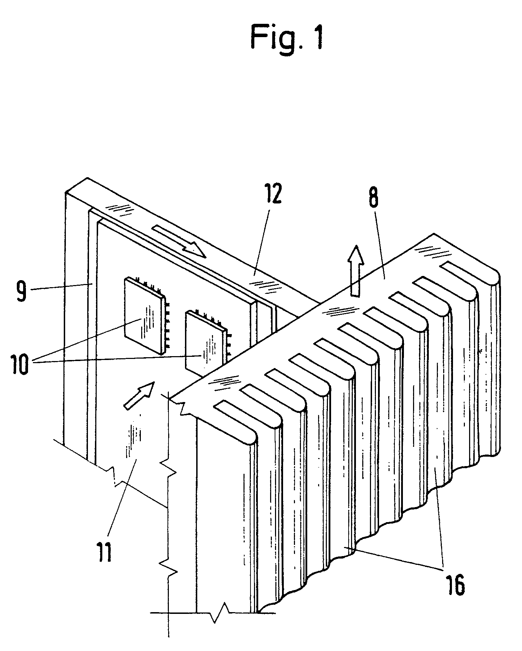

Das in Fig. 1 dargestellte Gerät ist ein auf dem Markt befindliches Elektronikgerät der Anmelderin. Die elektronischen Bauelemente 10 sind auf Substraten 11 (insbesondere aus Aluminiumoxid) angeordnet, und diese auf einer Trägerplatte 9, z.B. aus Aluminium. Die Substrate 11 sind relativ gut wärmeleitend und stehen über die Trägerplatten 9 in engem Wärmekontakt mit je einer Wärmeleitplatte 12, ebenfalls bevorzugt aus Aluminium. Die Wärmeleitplatten 12 übernehmen daher die Verlustwärme der Bauelemente 10 und leiten sie durch Wärmeleitung einer Wärmesenke 8 zu, mit der sie aufrecht stehend, rechtwinklig und wärmeleitend verbunden sind. Von den Substraten 11, Trägern 9 und Wärmeleitplatten 12 ist in Fig. 1 aus Gründen der Uebersichtlichkeit nur je eine gezeigt. Die Wärmesenke 8 besteht aus einer relativ dicken Metallplatte, z.B. aus Aluminium, die die aufgenommene Wärme verteilt und über Kühlrippen 16 der Umgebungsluft zuführt. Diese dienen als Wärmetauscher und geben die Wärme an vorbeiströmende Luft ab. Der Wärmefluss von den Elektronikkomponenten 10 über die Substrate 11 bis zur Kühlluft ist durch Pfeile angedeutet.

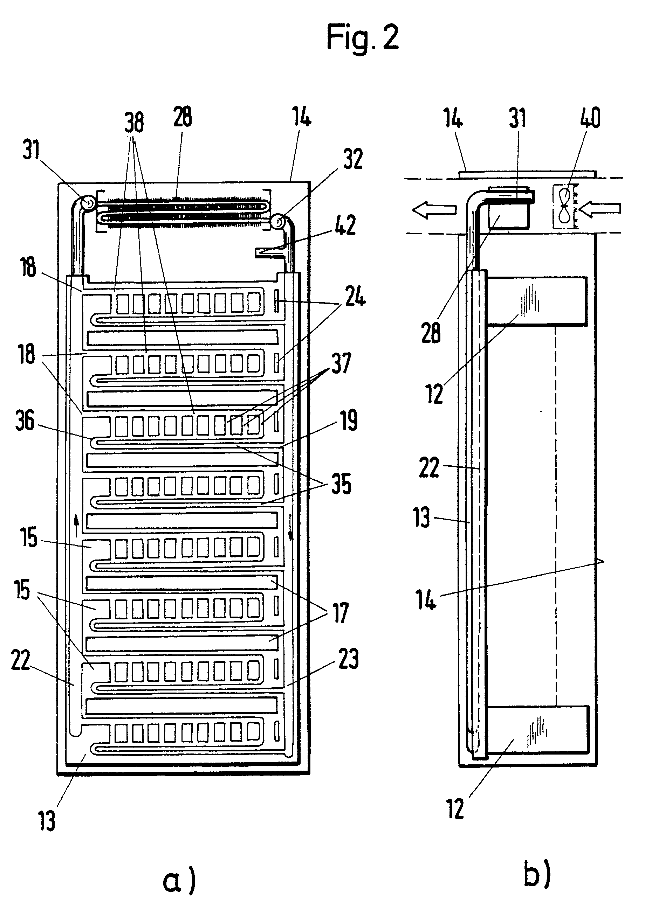

Die in Fig. 2 dargestellte Ausführungsform der erfindungsgemässen Vorrichtung hat ein plattenförmiges Element 13, welches die Rückwand eines Elektronikgestells 14 bildet. Das Gestell 14 weist acht Etagen auf, in die Substrate 11, die auf grösseren, wärmeleitfähigen Platten montiert sein können, von vorne einschiebbar sind. In Fig. 2b sind Wärmeleitplatten 12 entsprechend denen von Fig. 1 zu sehen, die parallel zu den eingeschobenen Substraten 11 und ggf. deren Trägerplatten 9 angeordnet sind und von diesen deren Wärem übernehmen.

Die Wärmeplatten 12 stehen in gutem Wärmekontakt mit Verdampfern 15 des Elements 13, von denen je einer einer Etage des Gestells 14 zugeordnet ist. Die Verdampfer 15 sind durch Durchbrüche 17 getrennt, die Wärmewiderstände bilden. Durch diese Durchbrüche 17 können z. B. elektrische Leitungen geführt oder Stecker zum elektrischen Kontaktieren der in den Etagen angeordneten Elektronik angeordnet werden.

Die in allen Etagen gleichen Verdampfer 15 sind ausgebildet als im wesentlichen plattenförmige, rechteckige Hohlkörper, die über je zwei Anschlüsse 18, 19 an zwei vertikale Rohre 22 und 23 des Elements 13 angeschlossen sind.

Die Rohre 22, 23 sind unten geschlossen und oben durch einen über dem Element 13 angeordneten Kondensator 28 miteinander verbunden, der zuoberst im Gestell 14 montiert ist. Die Verdampfer 15, die Rohre 22, 23 und der Kondensator 28 bilden eine druckdicht geschlossene Einheit, die mindestens bis zur Oberkante des obersten Verdampfers 15 und höchstens bis zum unteren Teil des Kondensators 28 mit einer Siedeflüssigkeit gefüllt ist. Die Siedeflüssigkeit ist vorzugsweise ein halogenisierter Kohlenwasserstoff, z.B. Trichlorfluormethan ($CCl_3F$) und so gewählt, dass sie bei dem sich in der Einheit einstellenden Betriebsdruck eine Siedetemperatur von etwa 25-30° C hat. Die Verlustwärme der elektronischen Baugruppen einer Etage wird durch die Wärmeleiter 12 zum Verdampfer 15 dieser Etage geleitet und an die Siedeflüssigkeit übertragen, so dass diese zu sieden beginnt. Die Dampfblasen führen die von der Flüssigkeit aufgenommene Wärme nach oben ab.

In jedem Verdampfer 15 strömen die entstehenden Blasen zu dessen oberen Anschluss 18, durch diesen in das Rohr 22 und darin aufwärts. Das Rohr 22 bildet also ein Steigrohr für die Dampfblasen. Die Blasen und bei starkem Sieden die durch die Blasen mitgerissene, unverdampfte Siedeflüssigkeit erreichen den Kondensator 28 über dessen oberen Anschluss 31. Im Kondensator wird das Blasen/Flüssigkeitsgemisch unter die Siedetemperatur gekühlt und die Blasen kondensiert. Die kondensierte, blasenfreie Flüssigkeit strömt infolge ihrer relativ höheren Dichte unter dem Einfluss der Schwerkraft von oben nach unten durch das zweite senkrechte Rohr 23 (Fallrohr) der Einheit und tritt durch die unteren Anschlüsse 19 der Verdampfer 15 in diese ein, wo sie wiederum unter Bildung von Blasen verdampft. Die Siedeflüssigkeit und die Blasen unterliegen damit einem kräftigen Naturumlauf. Eine Umwälzpumpe ist nicht erforderlich.

Der Hohlraum jedes Verdampfers 15 umfasst bevorzugt drei waagrechte Rohrabschnitte 35, 36, 38 und eine Mehrzahl vertikaler Rohrabschnitte 37, die wie folgt miteinander verbunden sind: Vom unteren Anschluss 19 verläuft der Rohrabschnitt 35 waagrecht parallel zum Durchbruch 17 über dessen gesamte Länge, bevor er eine Biegung um 180° nach oben macht und als zweiter waagrechter Rohrabschnitt 36 parallel zum Abschnitt 35 in der umgekehrten Richtung weiterläuft. Vom Abschnitt 36 zweigen verteilt über dessen ganze Länge die vertikalen Rohrabschnitte 37 parallel und in etwa gleichen Abständen nach oben ab. Die Abschnitte 37 münden oben in den dritten waagrechten Rohrabschnitt 38 ein. Dieser endet im oberen Anschluss 18, der diagonal zum unteren Anschluss 19 liegt. Diese bevorzugte Ausbildung der Verdampfer 15 entwickelt unabhängig von deren Lage im Element 13, d.h. unabhängig davon, ob der Verdampfer 15 oben oder unten im Gestell 14 angeordnet ist, und unabhängig von der jeweils aufzunehmenden Wärmemenge eine Art von Ventilwirkung, die praktisch nur eine Blasen- und Flüssigkeitsströmung vom tiefer gelegenen Anschluss 19 in Richtung zum höher gelegenen Anschluss 18 des jeweiligen Verdampfers 15 zulässt. Hierdurch wird gewährleistet, dass jede Etage des Elektronikgestells 14 unabhängig von den anderen Etagen jederzeit in der Lage ist, die in der Etage jeweils anfallende Wärmemenge aufzunehmen und gerichtet zum Steigrohr 22 abzuführen.

Um zu verhindern, dass Wärme von den Verdampfern 15 zum Fallrohr 23 fliesst, ist es vorteilhaft, weitere Durchbrüche 24, ähnlich wie die Durchbrüche 17, vorzusehen, die zwischen den Verdampfern 15 und dem Fallrohr 23 angeordnet sind.

Wegen der im Vergleich zur reinen Flüssigkeit geringeren Dichte des Blasen/Flüssigkeitsgemisches im Steigrohr 22 und des damit erhöhten Volumens wird dieses Rohr bevorzugt mit grösserem Querschnitt ausgerüstet als das Fallrohr 23, das nur Flüssigkeit enthält.

Das über das Steigrohr 22 ankommende Gemisch aus Blasen und Flüssigkeit wird, wie bereits beschrieben, im Kondensator 28 unter Wärmeentzug kondensiert. Der Kondensator 28 kann entweder als Luftwärmetauscher (wie dargestellt) oder z.B. als Wasserwärmetauscher ausgebildet sein. In beiden Fällen wird ihm über das Steigrohr 22 zentral die gesamte im Elektronikgestell 14 anfallende Wärme zugeführt und in ihm an den Wärmeträger Luft, Wasser o. dgl. abgegeben.

Die Bereitstellung des Kühlmediums Luft, z.B. durch einen oder mehrere Lüfter 40, oder des Kühlmediums Wasser kann in Abhängigkeit vom jeweiligen Wärmeanfall und von der Kühlmedium-Anfangstemperatur erfolgen. Hierzu werden beispielsweise die Lüftermotoren 40 oder ein Wasserreduzierventil so gesteuert, dass zwischen den Anschlüssen 31 und 32 des Kondensators 28 eine genügende, jedoch nicht eine maximal mögliche Temperaturdifferenz auftritt, bei der genannten Flüssigkeit und deren Siedetemperatur beispielsweise 5 bis 8°C.

Bei Verwendung des Kühlmeidums Luft kann diese der Umgebung des Elektronikgestells 14 entnommen und wieder an diese Umgebung abgegeben werden. Vorteilhafter ist es jedoch, die Kühlluft über Ventilationskanäle so zu führen, dass die Umgebung des Elektronikgestells 14 keinerlei Temperaturbeeinflussung durch die im Elektronikgestell 14 anfallende Verlustwärme erfährt.

Zum Schutz gegen Ueberhitzung, z.B. bei Ausfall eines Lüftermotors 40, kann eine Ueberwachung der Absoluttemperatur vorgesehen werden, die einen gewissen Maximalwert nicht überschreiten darf. Weiter kann noch eine Schmelzsicherung für das Rohrsystem der Einheit 13, 28 vorgesehen sein, insbesondere ein Verschluss aus Woodschem Metall, der z.B. im randfall, bei der relativ tiefen Temperatur von etwa 90°C anspricht und ein Explodieren der Vorrichtung verhindert.

Die Einheit der Verdampfer 15 und Rohre 22, 23 wird vorteilhaft in einem gemeinsamen Herstellungsprozess hergestellt, bei dem in an sich bekannter Weise zwei Bleche so miteinander verlötet oder verschweisst werden, dass eine (unverbundene) Rohrstruktur gebildet wird, die dann in einer Form unter hohem Druck zu Rohren aufgeblasen wird. Diese Art der Herstellung ist preisgünstig und besitzt den wesentlichen Vorteil, dass das gesamte Rohrsystem der Einheit 13 entsprechend Fig. 2 nur zwei Verbindungsstellen, und zwar bei den Anschlüssen 31, 32 des Kondensators 28 aufweist. Die Durchbrüche 17 und 24 sowie eventuell andere Löcher, die z.B. für Befestigungszwecke vorgesehen sind, lassen sich vor oder nach dem Aufblasen der Rohre durch Stanzen leicht herstellen.

Das Rohrsystem der Einheit 13, 28 wird über einen Füllstutzen 42 mit der beschriebenen Siedeflüssigkeit 30 gefüllt und bezüglich seines Druckes eingestellt. Der Füllstutzen 42 wird nach dem Füllen z.B. durch Abquetschen gedichtet. Am Füllstutzen 42 lassen sich auch bequem die genannte Schmelzsicherung anbringen sowie ggf. ein Vorrats- und Ausgleichsgefäss für überschüssige Siedeflüssigkeit.

Bei der Herstellung der die Verdampfer 15 und Rohre 22, 23 umfassenden Einheit 13 in einem Stück nach dem genannten Verfahren werden die Verdampfer 15 in einer Ebene gebildet, und sind daher unmittelbar geeignet, als z.B. ebene Rückwand eines grösseren Elektronikgestells 14. Zur Verbesserung des Wärmeübergangs zwischen den rechtwinklig zur Rückwand angeordneten Wärmeleitplatten 12 und den Verdampfern 15 lassen sich an die letzteren angeschmiegte Wärmeausgleichplatten anordnen, die zusätzlich für eine verbesserte mechanische Stabilität sorgen.

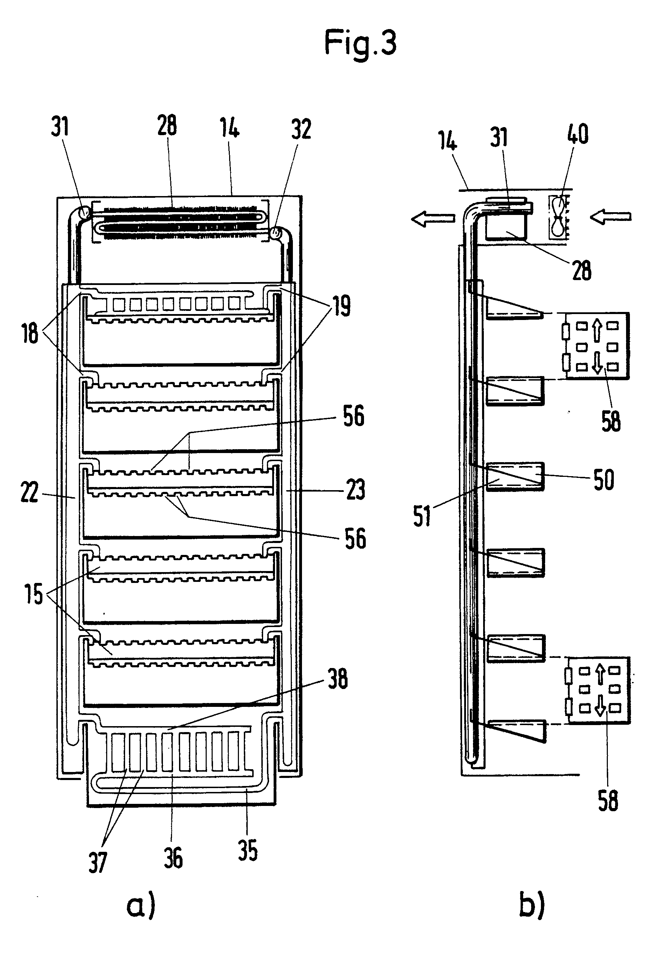

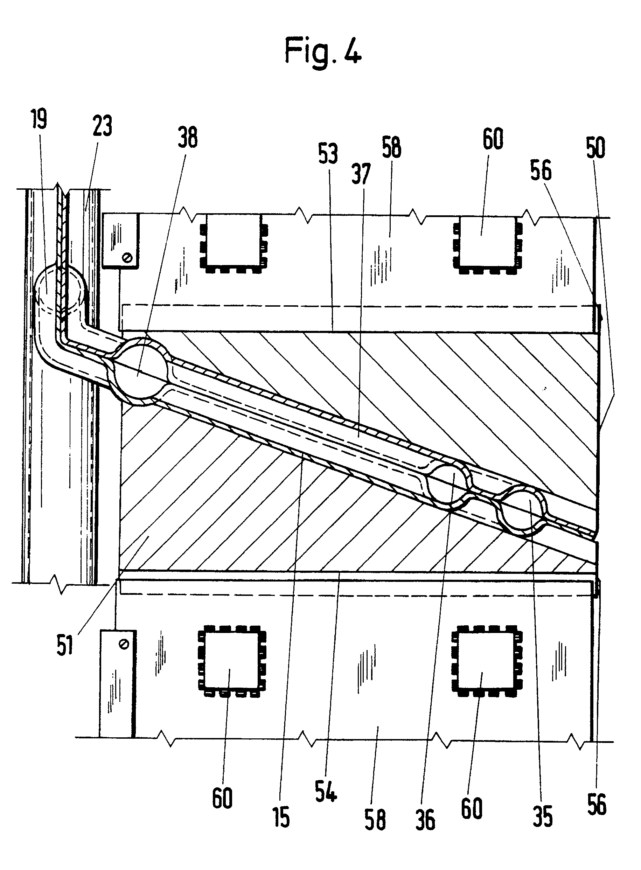

Abweichend von der oben beschriebenen Anordnung der Verdampfer 15 in einer Ebene, können diese durch geeignetes Biegen der fertigen Einheit auch geneigt angeordnet werden. Fig. 3 und 4 zeigen eine solche Variante der Vorrichtung. Die Verdampfer 15 sind bis auf den untersten nach geeignetem Freistanzen aus einer Anordnung entsprechend Fig. 2 nach vorne aus der die Rückwand bildenden Einheit 13 so herausgebogen, dass sie eine Neigung zur Horizentralen von etwa 5 bis 20° aufweisen. Der in Fig. 4 dargestellte Schnitt verläuft durch einen Verdampfer 15 längs eines Rohrabschnitts 37 und quer zu den horizontalen Rohrabschnitten 35, 36 und 38. (Der in Fig. 2 vertikale Rohrabschnitt 37 ist in Fig. 3 und 4 geneigt). Nicht geschnitten, im Hintergrund von Fig. 4, ist das Rohr 23 und ein Anschluss des Verdampfers 15 an dieses Rohr 23 zu sehen.

Der dem Verdampfer 15 von Fig. 2 bis auf die Lage vollständig entsprechende Verdampfer 15 der Variante von Fig. 3 und 4 trägt auf beiden Seiten einen Wärmeleiter 50 bzw. 51, z.B aus Aluminium. Diese sind mit dem Verdampfer 15 gut wärmeleitend verbunden, z.B. mit ihr verschraubt, und keilförmig ausgebildet. Ihre freiliegenden Flächen 53 bzw. 54 verlaufen horizontal und tragen eine Mehrzahl von Nuten 56, von denen lediglich je eine geschnitten sichtbar ist. In diese Nuten 56 werden Trägerplatten 58 für elektronische Schaltkreise, Komponenten bzw. Bauelemente 10 eingeschoben.

Die Trägerplatten 58 entsprechen konventionellen, gedruckten Leiterplatten, sind jedoch so ausgebildet, z.B. durch eine innere Wärmeleitschicht aus Kupfer, dass sie die Verlustwärme der Komponenten 10 längs der Platte 58 zum jeweiligen Wärmeleiter 50 bzw. 51 leiten, die die Wärme aufnehmen und an den Verdampfer 15 abgeben.

Sind eine Mehrzahl von Verdampfern 15 und Wärmeleitern 50, 51 in einem Elektronikgestell 14 vorgesehen, z.B. wie in Fig. 3 gezeigt, so lassen sich Trägerplatten 58 analog wie in konventionelle Gestelle einzeln einschieben, herausziehen und auswechseln.

Die beschriebene Vorrichtung hat den wesentlichen Vorteil, dass die Verlustwärme der Elektronik effizient einem zentralen Kondensator 28 zugeführt wird, der sie bei geeigneter Ausbildung, z.B. über einen Warmluftschacht oder eine Warmwasserleitung, ohne Beeinflussung der Gestellumgebung abführen kann. Die Leitung der Wärme im Elektronikgestell 14 erfolgt dabei so, dass sich nirgends Wärmestaus ergeben können und eine gegenseitige Beeinflussung von Wärmeerzeugern weitgehend ausgeschlossen ist. Insgesamt wird somit im Elektronikgestell 14 eine stabile und gleichmässige Temperatur gewährleistet, die weitgehend unabhängig ist von der Temperatur der Gestellumgebung. Bei Halbleiterbauelementen lässt sich damit sicherstellen, dass die maximal zulässige Temperatur der Sperrschichten nicht überschritten wird.

Die Vorrichtung ist einfach herstellbar und universell einsetzbar für grosse und kleine Elektronikgestelle 14. Für die Bestückung der Gestelle bestehen weitgehende Freiheiten, sofern gewisse Wärmehöchstleistungen nicht überschritten werden. Versuche haben ergeben, dass pro Etage bis zu etwa 700 W und bei einem Gestell mit 10 Etagen insgesamt bis etwa 4 kW ohne weiteres abführbar sind.

Die Ausgestaltung des Aufbaus der Elemente 13 erlaubt zahlreiche Varianten. So ist die Zahl der Verdampfer 15 bzw. die Anzahl Etagen pro Elektronikgestell sowie deren Geometrie bezüglich Breite und Höhe frei wählbar. Es kann auch nur ein einziger Verdampfer 15 pro Elektronik-Gestell vorgesehen sein. Der Hohlkörper des Verdampfers 15 kann auch anders ausgestaltet sein. Zum Beispiel kann der Rohrabschnitt 36 statt am linken Ende etwa in der Mitte mit dem entsprechend kürzer ausgeführten Rohrabschnitt 35 verbunden sein. Weiter kann anstelle der Rohrabschnitte 36, 37, 38 ein gemeinsamer z.B. rechteckiger Hohlraum gebildet sein. Beachtet werden sollte jedoch, dass der Anschluss 19 mit dem unteren Teil und der Anschluss 18 mit dem oberen Teil des Hohlraums in Verbindung steht, um die richtige Umlaufrichtung der Blasen und der Flüssigkeit im Kreislauf durch den Kondensator 28 zu erreichen.

Schliesslich können die Rohre 22, 23 aus der Ebene des Elements 13 z.B. um 90° nach hinten gebogen sein, was aus Platzgründen vorteilhaft sein kann, indem das Element dadurch schmaler wird.

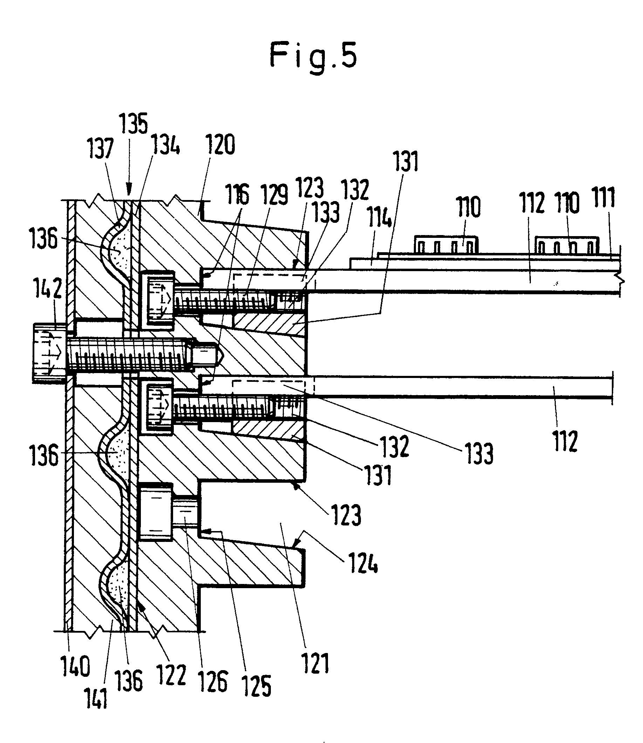

Bei der in Fig. 5 dargestellten Ausführungsform sind Elektronikelemente 110, vorzugsweise integrierte Halbleiterschaltkreise, auf Substratplatten 111, z.B. aus Aluminiumoxid, angeordnet. Diese sind mit Wärmeleitplatten 112 breitflächig verbunden, entweder direkt oder über eine wärmeleitfähige Trägerplatte 114, welche die Stabilität der Substratplatte 111 erhöht.

Die Wärmeleitplatten 112 sind ebene, rechteckige Platten von etwa 2 bis 3 mm Dicke und einer Fläche von bis zu 15 x 30 cm, bevorzugt aus Aluminium, die z.B. durch Stanzen aus Plattenmaterial hergestellt sind. Die Wärmeleitplatten 112 können auch als plattenförmige, in sich abgeschlossene Hohlkörper ausgebildet sein, die mit einer Siedeflüssigkeit gefüllt sind. In diesem Fall erfolgt der Wärmetransport wie bei einem Wärmerohr (Heat pipe) durch Verdampfen und Kondensieren der Flüssigkeit an verschiedenen Stellen der Wärmeleitplatten 112.

Die Wärmeleitplatten 112 stehen mit ihren in Fig. 5 linken Randflächen 116 und oberen Seitenflächen 123 in Wärmekontakt mit einem als Wärmepuffer dienenden Körper 120 hoher Wärmekapazität. Dieser ist ein Guss- oder Ziehteil, bevorzugt aus Aluminium, der auf seiner einen (Fig. 5 linken) Seite eine plane Fläche 122 und auf seiner anderen (in Fig. 5 rechten) Seite eine Mehrzahl paralleler Keilnuten 121 aufweist.

Die eine Keilflanke 123 der Keilnuten 121 verläuft horizontal, die andere Flanke 124 schräg nach unten und der ebene Nutboden 125 steht rechtwinklig zur Flanke 123. Der Keilwinkel beträgt bevorzugt 5°.

Jeder Nut 121 ist eine Bohrung 126 zugeordnet, die die plane Fläche 122 mit dem Nutboden 125 verbindet und zum Einstecken einer Schraube 129 dient. Die Bohrung ist auf der Seite der planen Fläche 122 erweitert, so dass der Schraubenkopf, z.B. der zylindrische Kopf einer Imbusschraube, versenkt ist.

Zum Herstellen eines guten Wärmekontaktes zwischen den Wärmeleitplatten 112 und dem Körper 120 ist in jede der Nuten 121 ein an die Form der Nuten angepasstes Keilstück 131 eingepresst. Jedes Keilstück 131 wird durch eine der Schrauben 129 angezogen und gehalten, wobei aufgrund der Keilform ein erheblicher seitlicher Anpressdruck zwischen der jeweiligen Wärmeleitplatte 112 und der zugeordneten ersten Keilflanke 121 auftritt.

Das Keilstück 131 weist auf seiner Fläche, die mit der jeweiligen Wärmeleitplatte 112 in Wärme-

kontakt steht, kleinflächige Erhöhungen (nicht dargestellt) auf, mit denen es unter plastischer Verformung in die Wärmeleitplatte 112 eindringt. Hierdurch wird beim Festziehen der Schraube 129 eine Kraftkomponente in Richtung zum Nutboden 125 wirksam, die die Wärmeleitplatte 112 mit ihrer Seitenfläche 116 in Anschlagposition mit dem Nutboden 125 bringt. Das Keilstück 131 weist weiter an der Stelle der Gewindebohrung 132 eine Erhöhung 132 auf, die zum Zwecke der Zentrierung in einen zugeordneten Schlitz der Wärmeleitplatte 112 eingreift. Auf diese Weise ist ohne besonderen Aufwand eine sehr genaue Ausrichtung der Wärmeleitplatten 112 senkrecht zum Körper 120 gewährleistet.

Der Körper 120 liegt mit seiner planen Fläche 122 an der einen Seite 134 eines Verdampfers 135 an. Der Verdampfer 135 ist einer von mehreren Verdampfern eines aus zwei druckdicht miteinander verbundenen Blechen 134, 137 gefertigten Elements, das dem Element 13 entspricht. Der Teil des Blechs 134, an dem der Körper 20 anliegt, ist plan oder nahezu plan, das Blech 137 hat gewölbte und plane Bereiche. Die gewölbten Bereiche des Blechs 137 bilden mit dem Blech 134 Hohlräume 136 (entsprechend den Rohrabschnitten 35-38 des Elements 13) für die Flüssigkeit, die planen Bereiche des Blechs 137 sind druckdicht mit dem Blech 134 verbunden (z.B. verschweisst oder verlötet). Das Blech 137 kann statt gewölbte auch z.B. rechteckig ausgebuchtete Bereiche haben, so dass die Hohlräume 136 einen z.B. viereckigen Querschnitt aufweisen.

Der Körper 120 steht kraftschlüssig und mit Druck mit einer ebenen Halteplatte 140 in Verbindung. Der Druck von dieser Platte 40 zum Körper 120 wird durch eine elastische Zwischenlage 141 und über den Verdampfer 135 vermittelt, während wenige, z.B. zwei Schrauben 142 die Zugkräfte zwischen der Halteplatte 140 und dem Körper 120 aufbringen. Der Druck wird so bemessen, dass die plane Fläche 122 des Körpers 120 und die plane oder nahezu plane Fläche 134 des Verdampfers 135 möglichst grossflächig und zwischenraumfrei gegeneinandergedrückt sind.

Die Halteplatte 140 kann als dickeres Blech von z.B. 10 mm Dicke oder als dünnes, seitlich abgekantetes und in der Mitte mit Versteifungsstreifen versehenes Blech ausgebildet sein.

Die Zwischenlage 141 ist bevorzugt ein Schaumgummi, der zusätzlich zur elastischen Verbindung eine für die Verdampfung der Flüssigkeit im Verdampfer 135 günstige Wärmeisolierung zwischen dem Verdampfer 135 und der Halteplatte 140 bewirkt. Die Zwischenlage 141 kan ein ebenes Plattenmaterial sein, das stärker an die ausgebuchteten Bereiche des Blechs 137 gepresst wird, oder es kann den Ausbuchtungen entsprechende Einbuchtungen aufweisen, so dass eine weitgehend gleichmässige Flächenpressung entsteht. Um langzeitlich gleiche Verhältnisse zu gewährleisten, muss die Zwischenlage 141 alterungsbeständig und dauerelastisch sein.

Die Herstellung der Vorrichtung ist einfach und billig: Die Wärmeleitplatten 112 werden rechteckig aus Plattenmaterial ausgeschnitten, bzw. -gestanzt. Die Keilstücke 131 sind einfache Frästeile aus Aluminium mit einem Schraubgewinde. Der Körper 120 wird entweder aus Plattenmaterial gefräst oder vorteilhafter gegossen oder gezogen. Die Montage erfolgt durch Zusammenstecken der genannten Teile und durch Anziehen der Schrauben 129.

Die vormontierten Wärmeleitteile 112, 120 werden sodann nach Art einer Sandwich-Konstruktion durch Verschrauben mit dem Verdampfer 135, der Zwischenlage 141 und der Halteplatte 140 vereint.

Die so zum Zwecke der Wärmeleitung verbundenen Teile weisen an allen Kontaktflächen eine erhebliche Flächenpressung auf, durch die zum einen die Teile formstabil miteinander verbunden sind, und durch die zum anderen Unebenheiten der Oberfläche zumindest teilweise ausgeglichen werden. Die Teile benötigen aus diesem Grund keine sehr präzise Bearbeitung. Die einzuhaltenden Toleranzen sind gering. Eventuelles Einbringen von Wärmeleitung fördernden Materialien zum Ausfüllen der verbleibenden Hohlräume, z.B. einer hochviskosen Wärmeleitpaste, kann die Toleranzen weiter vermindern.

Die Vorrichtung ist flexibel, lässt sich leicht an die jeweiligen Gegebenheiten der zu kühlenden Elektronik anpassen, z.B. an die Zahl der jeweiligen Substratplatten 111, an eine waagrecht liegende oder senkrecht stehende Anordnung der Substratplatten 111, deren Grösse usw. und ist jederzeit demontierbar.

## Ansprüche

1. Vorrichtung zum Abführen der Verlustwärme von mehreren etagenweise übereinander angeordneten Baugruppen elektrischer Elemente (10), mit mehreren in Abständen übereinander angeordneten Verdampfern (15; 135), die je durch einen Wärmeleiter (112, 120) mit der bzw. den in einer Etage angeordneten Baugruppe bzw. -gruppen elektrischer Elemente (10) wärmeleitend zu verbinden und parallel zueinander mit je einem Anschluss (18) oben an eine erste Leitung (22) und mit einem anderen Anschluss (19) an eine zweite Leitung (23) angeschlossen sind, einem oberhalb der Verdampfer (15; 135) angeordneten Kondensator (28) mit einem mit der ersten Leitung (22) verbundenen Einlass (31) und einem mit der zweiten Leitung (23) verbundenen Auslass (32), wobei die Verdampfer (15; 135), die beiden Leitungen (22, 23) und der Kondensator (28) mit seinen Anschlüssen an die beiden Leitungen (22, 23) eine druckdicht geschlossene Einheit bilden, welche mit einer Flüssigkeit soweit gefüllt ist, dass der oberste Verdampfer (15; 135) ganz oder mindestens teilweise und der Kondensator nicht oder höchstens teilweise gefüllt ist, so dass infolge der durch die Wärmeleiter (112, 120) den Verdampfern (15; 135) zugeleiteten, von der Flüssigkeit unter Bildung von Dampfblasen aufgenommen Verlustwärme der Baugruppen elektrischer Elemente (10) ein stetiger Dampf-Flüssigkeits-Kreislauf von den Verdampfern (15; 135) durch die erste Leitung (22) nach oben zum die Wärme an einen Wärmeträger abgebenden Kondensator (28) und von diesem durch die zweite Leitung (23) nach unten zurück zu den Verdampfern (15; 135) entsteht, dadurch gekennzeichnet, dass die Verdampfer (15; 135) und die beiden Leitungen (22, 23) aus zwei unter Bildung von Hohlräumen für die Verdampfer und Leitungen (15; 135; 22, 23) zu einem plattenartigen Verdampfer- und Leitungs-Element (13) druckdicht vereinigten Blechen (134, 137) gebildet und die Verdampferhohlräume (35-38; 136) zwischen den beiden Leitungshohlräumen (22, 23) angeordnet sind.

2. Vorrichtung nach Anspruch 1, dadurch gekennzeichnet, dass jeder Verdampferhohlraum (35-38; 136) durch ein verzweigtes Leitungshohlraumnetz (18, 19, 35, 36, 37, 38) gebildet ist, dessen Zweige (37) oben (18) in einen mit dem ersten Leitungshohlraum (22) verbundenen Netzabschnitt (38) und unten (19) in einen mit dem zweiten Leitungshohlraum (23) verbundenen Netzabschnitt (35, 36) münden.

3. Vorrichtung nach Anspruch 2, dadurch gekennzeichnet, dass das Leitungshohlraumnetz (18, 19, 35, 36, 37, 38) jedes Verdampfers (15; 135) drei übereinander angeordnete, sich im wesentlichen über die ganze Länge des Verdampfers (15; 135) erstreckende Netzabschnitte (35, 36, 38) und eine Vielzahl wenigstens annähernd vertikaler Zweige (37) umfasst, wobei der zweite Leitungshohlraum (23) durch den unteren Abschnitt (35) mit dem mittleren Abschnitt (36), der letztere über annähernd seine ganze Länge durch die Zweige (37) mit dem oberen Abschnitt (38) und dieser mit dem ersten Leitungshohlraum (22) verbunden ist.

4. Vorrichtung nach einem der Ansprüche 1 bis 3, dadurch gekennzeichnet, dass die beiden Bleche (134, 137) zwischen den Verdampferhohlräumen (35-38; 136) und/oder zwischen den Verdampferhohlräumen (35-38; 136) und dem zweiten Leitungshohlraum (23) zur Vermeidung der Wärmeleitung Durchbrüche (17, 24) aufweisen.

5. Vorrichtung nach einem der Ansprüche 1 bis 4, dadurch gekennzeichnet, dass das plattenartige Verdampfer- und Leitungs-Element (13) die Rückwand eines die Baugruppen elektrischer Elemente aufnehmenden Gestells (14) bildet.

6. Vorrichtung nach einem der Ansprüche 1 bis 5, dadurch gekennzeichnet, dass die Verdampferhohlräume (35-38; 136) und die beiden Leitungshohlräume (22, 23) in einer gemeinsamen, vertikalen Ebene liegen.

7. Vorrichtung nach einem der Ansprüche 1 bis 6, dadurch gekennzeichnet, dass eine der beiden Blechwandungen (134, 137) jedes Verdampferhohlraums (136) grossflächig mit je einem als Wärmepuffer wirkenden, wärmeleitfähigen Körper (120) verbunden ist, der wärmeleitend mit der bzw. den Baugruppen elektrischer Elemente (110) zu verbinden (112) ist.

8. Vorrichtung nach Anspruch 7, dadurch gekennzeichnet, dass der die eine Seite des Verdampfers (135) bildende Teil des einen Blechs (134) wenigstens annähernd eben und der die andere Seite des Verdampfers (135) bildende Teil des anderen Blechs (137) zur Bildung der Verdampferhohlräume (136) ausgebuchtete und dazwischen ebene, dicht mit dem einen Blech (134) verbundene Bereiche hat, und dass der Körper (120) wenigstens annähernd mit der gesamten Fläche des die eine Seite des Verdampfers (135) bildenden Blechteils (134) verbunden ist.

9. Vorrichtung nach Anspruch 8, dadurch gekennzeichnet, dass der die andere Seite des Verdampfers (135) bildende Blechteil (137) mit einer wärmedämmenden Schicht (141) abgedeckt ist.

10. Vorrichtung nach einem der Ansprüche 7 bis 9, dadurch gekennzeichnet, dass der bzw. jeder Körper (120) wenigstens eine Aufnahme (121) und ein Befestigungsmittel (131) für einen mit der bzw. den Baugruppen elektrischer Elemente (110) zu verbindenden bzw. diese tragenden Wärmeleiter (112) aufweist.

11. Vorrichtung nach einem der Ansprüche 7 bis 9, dadurch gekennzeichnet, dass der bzw. jeder Körper (120) an der dem Verdampfer (135) abgewandten Seite eine oder mehrere in Abständen übereinander angeordnete, horizontale Keilnuten (121) aufweist, und für jede Keilnut ein Keilstück (131) vorgesehen ist, mittels dem ein plattenförmiger, mit der bzw. den Baugruppen elektrischer Elemente (110) zu verbindender bzw. diese tragender Wärmeleiter (112) in der Keilnut (121) festklemmbar ist.

12. Vorrichtung nach Anspruch 11, dadurch gekennzeichnet, dass das Keilstück (131) an einer Keilflanke kleinflächige Erhöhungen aufweist, die so ausgebildet sind, dass sie in den Wärmeleiter (112) einzudringen vermögen.

13. Vorrichtung nach Anspruch 11 oder 12, dadurch gekennzeichnet, dass jedes Keilstück (131) mittels einer Schraube (129) in Keilrichtung am Körper (120) festzieh- und sicherbar ist.

14. Vorrichtung nach Anspruch 13, dadurch gekennzeichnet, dass der Körper (120) lösbar mit dem Verdampfer (135) verbunden (142) ist.

15. Vorrichtung nach Anspruch 7, dadurch gekennzeichnet, dass der Körper (120) mit einer mit einer Siedeflüssigkeit gefüllten, in sich abgeschlossenen Wärmeübertragungseinrichtung (112) verbunden ist, die wärmeleitend mit der bzw. den Baugruppen elektrischer Elemente (110) zu verbinden ist.

16. Vorrichtung nach Anspruch 4, dadurch gekennzeichnet, dass die die Verdampfer (15; 135) bildenden Blechteile zur Horizontalen geneigt sind, wobei der Neigungswinkel zwischen 5° und 20° beträgt und alle Verdampfer-Blechteile (15; 135) wenigstens annähernd denselben Neigungswinkel haben.

17. Vorrichtung nach Anspruch 16, dadurch gekennzeichnet, dass an jedem Verdampfer (15; 135) wenigstens ein Wärmeleiter (50, 51) wärmeleitend befestigt ist, der eine sich im wesentlichen horizontal erstreckende, freie Fläche (53, 54) aufweist, die mehrere parallele Nuten (56) aufweist, in welche die Baugruppe bzw. -gruppen elektrischer Elemente (60) einer Etage tragende, wärmeleitfähige Platten (58) zur Herstellung des Wärmekontakts einschiebbar sind.

18. Vorrichtung nach einem der Ansprüche 1 bis 17, dadurch gekennzeichnet, dass der erste Leitungshohlraum (22) einen grösseren Querschnitt als der zweite Leitungshohlraum (23) hat.

19. Vorrichtung nach einem der Ansprüche 1 bis 18, dadurch gekennzeichnet, dass die Flüssigkeit ein halogenisierter Kohlenwasserstoff ist, insbesondere Trichlorfluormethan, dessen Siedetemperatur unter Betriebsdruck etwa 25 bis 30 °C beträgt.

20. Vorrichtung nach einem der Ansprüche 1 bis 19, mit einer Fördereinrichtung (40) für den Wärmeträger, dadurch gekennzeichnet, dass das Fördervolumen des Wärmeträgers so geregelt ist, dass die Temperatur am Einlass (31) des Kondensators (28) annähernd 5 bis 8 °C über derjenigen am Auslass (32) liegt.

## Claims

1. Device for extracting waste heat of several stacked assembly groups of electrical elements (10), with several evaporators (15; 135), which are stacked with gaps inbetween and which are each to be heat-conductingly connected by a heat conductor (112, 120) to the stacked assembly group(s) of electrical elements (20) and connected parallel to one another with each one connection (18) at the top to a first pipe (22) and with another connection (19) to a second pipe (23), with a condenser (28), which is arranged above the evaporators (15; 135), including an inlet (31) connected to the first pipe (22) and an outlet (32) connected to the second pipe (23), in which respect. the evaporators (15; 135), the two pipes (22, 23) and the condenser (28) with its connections to the two pipes (22,23) form a pressure-tight sealed unit which is filled with a liquid to such an extent that the uppermost evaporator (15; 135) is fully or at least partially filled, and the condenser is not or not more than partially filled, thus establishing, by virtue of waste heat of the assembly groups of electrical elements (10), which heat is ducted via the heat conductors (112, 120) to the evaporators (15; 135) and picked up by the liquid whilst forming vapour bubbles, a constant vapour-liquid circulation from evaporators (15; 135) through the first pipe (22) upwards to the condenser (28), which transfers the heat to a heat conductor, and from this condenser through a second pipe (23) downwards back to the evaporators (15; 135), **characterised in that** the evaporators (15: 135) and the two pipes (22, 23) are formed by two sheets (134, 137), joined pressure-tight into a plate-like evaporator- and ducting element (13) whilst establishing hollow spaces for the evaporators and pipes (15; 135;

22, 23), and in that the hollow evaporator spaces (35-38; 136) are arranged between the two hollow pipe spaces (22, 23).

2. Device according to claim 1, **characterised in that** each hollow evaporator space (35-38; 136) is formed by a branched hollow pipe-space net (18, 19, 35, 36, 37, 38), the branches (37) at the top (18) terminating in a net section (38) which is connected to the first hollow pipe-space net (38), and at the bottom (19) terminating in the net section (35, 36) which is connected to the second hollow pipe space (23).

3. Device according to claim 2, **characterised in that** the hollow pipe-space net. (18, 19, 35, 36, 37, 38) of each evaporator (15; 135) includes three stacked net sections (35, 36, 38) which extend substantially over the entire length of the evaporator (15; 135), and a plurality of at least approximately vertical branches (37), in which respect the second hollow pipe space (23) is connected via the lower section (35) to the middle section (36), the latter in virtually its entire length via its branches (37) to the upper section (38), and the latter to the first hollow pipe space (22).

4. Device according to one of claims 1 to 3, **characterised in that** the two sheets (134, 137) have passages (17, 24) between the hollow evaporator spaces (35-38; 136) and/or between the hollow evaporator spaces (34-38; 136) and the second hollow pipe space (23) so as to prevent heat conduction.

5. Device according to one of claims 1 to 4, **characterised in that** the plate-like evaporator-and pipe element (13) is the rear wall of a frame (14) which accommodates the assembly groups of electrical elements.

6. Device according to one of claims 1 to 5, **characterised in that** the hollow evaporator spaces (35-38; 136) and the two hollow pipe spaces (22, 23) are placed in a common vertical plane.

7. Device according to one of claims 1 to 6, **characterised in that** one of the two sheet walls (134, 137) of each hollow evaporator space (136) is connected over a large surface with each one heat-conducting body (120) acting as heat buffer, which is to be heat-conductingly connected (112) to the assembly group(s) of electrical elements (110).

8. Device according to claim 7, **characterised in that** the part of the one sheet (134), which forms one side of the evaporator (135), is at least virtually level, and that the part of the other sheet (137), which forms the other side of the evaporator (135), has regions which are indented areas for forming the hollow evaporator spaces (136) and thereinbetween level areas, which are closely connected to the one sheet (134), and in that the body (120) is at least virtually connected to the entire surface of the metal section (134) which forms one side of the evaporator (134).

9. Device according to claim 8, **characterised in that** the metal section (137) which forms the other side of the evaporator (135) is covered by a heat-damping coat (141).

10. Device according to one of claims 7 to 9, **characterised in that** the or each body (120) has at least one receiving means (121) and one fixing means (131) for a heat conductor (112) which is to be connected to, or supported by the assembly group(s) of electrical elements (110).

11. Device according to one of claims 7 to 9, **characterised in that** the or each body (120) has one or several spaced stacked horizontal wedge grooves (121) at the side facing away from the evaporator (135), and in that a wedge member (131) is provided for each wedge groove, by which a plate-shaped heat conductor (112), which is to be connected to the assembly group(s) of electrical elements (110), is clamped in the wedge groove (121).

12. Device according to claim 11, **characterised in that** the wedge member (131) has small-surface protrusions at one wedge flank, arranged in such a manner that they can penetrate into the heat conductor (112).

13. Device according to claim 11 or 12, **characterised in that** each wedge member (131) can be tightened and secured to the body (120) in the direction of the wedge by means of a bolt (129).

14. Device according to claim 13, **characterised in that** the body (120) is detachably connected (142) to the evaporator (135).

15. Device according to claim 7, **characterised in that** a body (120) is connected to a boiling-liquid filled, sealed heat-transfer means (112), which is to be heat-conductingly connected to the assembly group(s) of electrical elements (110).

16. Device according to claim 4, **characterised in that** the metal parts which form the evaporators (15; 135) are horizontally inclined, in which respect the inclination angle lies between 5° and 20°, and in that all metal parts of the evaporator (15; 135) have at least virtually the same inclination angle.

17. Device according to claim 16, **characterised in that** to each evaporator (15; 135) is heat-conductingly attached at least one heat conductor (50, 51) with a substantially horizontally extending free surface (53, 54) with several parallel grooves (56), into which are engaged heat-conductive plates (58), which support the assembly group(s) of electrical elements (60) of one level, in order to establish heat contact.

18. Device according to one of claims 1 to 17, **characterised in that** the first hollow pipe space (22) is of a larger cross-section than the second hollow pipe space (23).

19. Device according to one of claims 1 to 18, **characterised in that** the liquid is a halogenised hydrocarbon, in particular trichlorfluormethane, the boiling temperature of which under operating pressure is approximately 25 to 30°.

20. Device according to one of claims 1 to 19, including a conveying means (40) for the heat carrier, **characterised in that** the conveying volume of the heat carrier is regulated so that the temperature at the inlet (31) of condenser (28) is near 5 to 8° C above that of the outlet (32).

**Revendications**

1. Dispositif pour évacuer la chaleur dissipée de plusieurs groupes constitutifs d'éléments électriques (10), agencés en superposition par étages, comprenant plusieurs évaporateurs (15 ; 135) qui sont agencés en superposition avec espacements, doivent être mis en liaison thermiquement conductrice, par l'intermédiaire d'un conducteur thermique respectif (112, 120), avec le ou les groupes constitutifs d'éléments électriques (10), respectivement situé(s) dans un étage, et sont raccordés parallèlement les uns aux autres, en partie haute à un premier conduit (22) par l'intermédiaire d'un raccord respectif (18), et à un second conduit (23) par l'intermédiaire d'un autre raccord (19) ; et un condenseur (28) disposé au-dessus des évaporateurs (15 ; 135) et muni d'une entrée (31) reliée au premier conduit (22), ainsi que d'une sortie (32) reliée au second conduit (23), les évaporateurs (15 ; 135), les deux conduits (22, 23) et le condenseur (28) , avec ses raccords aux deux conduits (22, 23), formant un ensemble unitaire fermé tenant la pression, et empli d'un fluide en une quantité telle que l'évaporateur (15 ; 135) situé le plus haut soit totalement ou au moins partiellement empli, et que le condenseur ne soit pas empli ou le soit au maximum en partie, de telle sorte que, par suite de la chaleur dissipée des groupes constitutifs d'éléments électriques (10), dirigée vers les évaporateurs (15 ; 135) par l'intermédiaire des conducteurs thermiques (112, 120) et absorbée par le fluide, en formant des bulles de vapeur, il s'établisse une circulation permanente de vapeur-fluide qui part des évaporateurs (15 ; 135), parcourt le premier conduit (22) vers le haut, jusqu'au condenseur (28) cédant la chaleur à un agent caloporteur, puis retourne aux évaporateurs (15 ; 135) vers le bas, à partir dudit condenseur, en empruntant le second conduit (23) , caractérisé par le fait que les évaporateurs (15 ; 135) et les deux conduits (22, 23) sont formés par deux tôles (134, 137) réunies avec étanchéité à la pression, en formant des cavités pour les évaporateurs et les conduits (15 ; 135 ; 22, 23), en un élément (13) d'évaporation et de conduction, du type plaque, les cavités (35-38 ; 136) à évaporateurs étant intercalées entre les deux cavités à conduits (22, 23).

2. Dispositif selon la revendication 1, caractérisé par le fait que chaque cavité (35-38 ; 136) à évaporateur est formée par un réseau ramifié (18, 19, 35, 36, 37, 38) de cavités à conduits, dont les embranchements (37) débouchent, en partie haute (18), dans un tronçon de réseau (38) relié à la première cavité à conduit (22) et, en partie basse (19), dans un tronçon de réseau (35, 36) relié à la seconde cavité à conduit (23).

3. Dispositif selon la revendication 2, caractérisé par le fait que le réseau (18, 19, 35, 36, 37, 38) de cavités à conduits de chaque évaporateur (15 ; 135) comprend trois tronçons de réseau (35, 36, 38) superposés et s'étendant, pour l'essentiel, sur toute la longueur de l'évaporateur (15 ; 135), ainsi qu'un grand nombre d'embranchements (37) au moins approximativement verticaux, la seconde cavité à conduit (23) étant reliée au tronçon moyen (36) par l'intermédiaire du tronçon inférieur (35), ledit tronçon moyen étant relié au tronçon supérieur (38) par l'intermédiaire des embranchements (37), sur approximativement toute sa longueur, et le tronçon supérieur étant relié à la première cavité à conduit (22).

4. Dispositif selon l'une des revendications 1 à 3, caractérisé par le fait que les deux tôles (134, 137) présentent des perforations (17, 24) entre les cavités (35-38 ; 136) à évaporateurs et/ou entre les cavités (35-38 ; 136) à évaporateurs et la seconde cavité à conduit (23), en vue d'éviter la conduction thermique.

5. Dispositif selon l'une des revendications 1 à 4, caractérisé par le fait que l'élément (13) d'évaporation et de conduction, du type plaque, forme la paroi postérieure d'un bâti (14) recevant les groupes constitutifs d'éléments électriques.

6. Dispositif selon l'une des revendications 1 à 5, caractérisé par le fait que les cavités (35-38 ; 136) à évaporateurs et les deux cavités à conduits (22, 23) se trouvent dans un plan vertical commun.

7. Dispositif selon l'une des revendications 1 à 6, caractérisé par le fait que l'une des deux parois en tôle (134, 137) de chaque cavité (136) à évaporateur est reliée, par une grande superficie, à un corps respectif (120) thermiquement conducteur, qui agit comme un tampon de chaleur et doit être mis en liaison thermiquement conductrice (112) avec le ou les groupes constitutifs d'éléments électriques (110).

8. Dispositif selon la revendication 7, caractérisé par le fait que la partie de l'une (134) des tôles, formant l'un des côtés de l'évaporateur (135), est au moins approximativement plane, et la partie de l'autre tôle (137), formant l'autre côté de l'évaporateur (135), présente des régions à indentations et des régions intercalaires planes, reliées hermétiquement à l'une (134) des tôles, en vue de former les cavités (136) à évaporateurs ; et par le fait que le corps (120) est relié, au moins approximativement, à toute la surface de la partie en tôle (134) formant l'un des côtés de l'évaporateur (135).

9. Dispositif selon la revendication 8, caractérisé par le fait que la partie en tôle (137), formant l'autre côté de l'évaporateur (135), est recouverte d'une couche (141) thermiquement isolante.

10. Dispositif selon l'une des revendications 7 à 9, caractérisé par le fait que le ou, respectivement, chaque corps (120) présente au moins un logement (121) et un moyen de fixation (131) pour un conducteur thermique (112) qui doit être relié au(x) groupe(s) constitutif(s) d'éléments électriques (110), ou porte respectivement ce(s) dernier(s).

11. Dispositif selon l'une des revendications 7 à 9, caractérisé par le fait que le ou, respectivement, chaque corps (120) présente, du côté tourné à l'opposé de l'évaporateur (135), une ou plusieurs gorges horizontales de coincement (121) agencées en superposition avec espacements ; et il est prévu, pour chaque gorge de coincement, une cale (131) au moyen de laquelle un conducteur thermique (112) en forme de plaque, devant être relié au(x) groupe(s) constitutif(s) d'éléments électriques (110), ou portant respectivement ce(s) dernier(s), peut être fermement bloqué dans la gorge de coincement (121).

12. Dispositif selon la revendication 11, caractérisé par le fait que la cale (131) comporte, sur un flanc cunéiforme, des protubérances de petite superficie qui sont réalisées de manière à être en mesure de pénétrer dans le conducteur thermique (112).

13. Dispositif selon la revendication 11 ou 12, caractérisé par le fait que chaque cale (131) peut être bloquée et arrêtée sur le corps (120), dans le sens du coincement, au moyen d'une vis (129).

14. Dispositif selon la revendication 13, caractérisé par le fait que le corps (120) est relié (142) de manière libérable à l'évaporateur (135).

15. Dispositif selon la revendication 7, caractérisé par le fait que le corps (120) est relié à un dispositif (112) de transmission de chaleur en soi fermé, empli d'un fluide entrant en ébullition, et devant être mis en liaison thermiquement conductrice avec le ou les groupes constitutifs d'éléments électriques (110).

16. Dispositif selon la revendication 4, caractérisé par le fait que les parties en tôle formant les évaporateurs (15 ; 135) sont inclinées par rapport à l'horizontale, l'angle d'inclinaison étant compris entre 5° et 20°, et toutes les parties en tôle des évaporateurs (15 ; 135) présentant au moins approximativement le même angle d'inclinaison.

17. Dispositif selon la revendication 16, caractérisé par le fait qu'au moins un conducteur thermique (50, 51), fixé à chaque évaporateur (15 ; 135) de manière thermiquement conductrice, présente une surface libre (53, 54) qui s'étend pour l'essentiel horizontalement, et comporte plusieurs encoches parallèles (56) dans lesquelles, en vue d'établir le contact thermique, peuvent être introduites des plaques (58) thermiquement conductrices qui portent le ou les groupes constitutifs d'éléments électriques (60) d'un étage.

18. Dispositif selon l'une des revendications I à 17, caractérisé par le fait que la première cavité à conduit (22) possède une plus grande section transversale que la seconde cavité à conduit (23).

19. Dispositif selon l'une des revendications I à 18, caractérisé par le fait que le fluide est un hydrocarbure halogénisé, en particulier du trichlorofluorométhane, dont la température d'ébullition est d'environ 25 à 30° C sous la pression de service.

20. Dispositif selon l'une des revendications 1 à 19, présentant un dispositif (40) de refoulement de l'agent caloporteur, caractérisé par le fait que le volume refoulé de l'agent caloporteur est régulé de telle sorte que la température, à l'entrée (31) du condenseur (28), excède d'approximativement 5 à 8° C celle régnant à la sortie (32).

# Fig. 1

# Fig. 2

a)

b)

# Fig.3

a)                                                                    b)

# Fig. 4

EP 0 231 456 B1

Fig.5

17